# EUROPÄISCHE PATENTSCHRIFT

(11) **EP 3 028 814 B1**
(45) Veröffentlichungstag und Bekanntmachung des Hinweises auf die Patenterteilung: **01.09.2021**
(21) Anmeldenummer: 15188700.7
(22) Anmeldetag: 07.10.2015
(51) Int. Cl.: B25B 23/00, G05B 19/00, B25B 23/145, B25B 23/147, G05B 19/418

(54) **VERFAHREN ZUR ZUORDNUNG VON EINER EINEN SCHRAUBVORGANG BESCHREIBENDEN SCHAUBKURVE ZU EINEM DIE SCHRAUBKURVE STEUERNDEN SCHRAUBPROGRAMM**
METHOD FOR ALLOCATING A SCREW CURVE DESCRIBING A SCREW PROCESS TO A SCREW PROGRAM CONTROLLING THE SCREW CURVE
PROCEDE D'AFFECTATION D'UNE COURBE DE VISSAGE DECRIVANT UN PROCESSUS DE VISSAGE A UN PROGRAMME DE VISSAGE COMMANDANT LA COURBE DE VISSAGE

(30) Priorität: 03.12.2014 DE 102014224690
(43) Veröffentlichungstag der Anmeldung: 08.06.2016
(73) Patentinhaber: Robert Bosch GmbH, 70442 Stuttgart (DE)
(72) Erfinder: Kalia, Dhruv, 71540 Murrhardt (DE); Sailer, Alexander, 73571 Goeggingen (DE); Klauss, Michael, 71522 Backnang (DE); Grueter, Jens, 71336 Waiblingen (DE)

(56) Entgegenhaltungen:
- WO-A1-2010/066375
- DE-A1-102005 019 258
- DE-A1-102011 122 212
- "Rexroth Schraubsystem 350 3 608 878 302 Version AF | 2013-05 Deutsch Projektierung", , Mai 2013 (2013-05), XP55268196, Gefunden im Internet: URL:ftp://ftp.boschrexroth.pl/brc/PAT/Syst em%20350_Project%20Planning/3608878302_AF_ Sys350_DE.pdf [gefunden am 2016-04-25]
- None

## Beschreibung

Die vorliegende Erfindung betrifft ein Verfahren zur Zuordnung von einer einen Schraubvorgang beschreibenden Schraubkurve zu einem die Schraubkurve steuernden Schraubprogramm sowie eine entsprechende Vorrichtung gemäß den Oberbegriffen der Patentansprüche 1 und 6.

Derartige Schraubkurven können beispielsweise mit einem akkubetriebenen Schraubsystem gemäß der DE102011122212A1 oder einem integrierten Leit- und Kontrollsystem gemäß der WO2010066375A1 oder einem bei der DE102005019258A1 beschriebenen Schraubwerkzeug erstellt werden. "Rexroth Schraubsystem 350 3 608 878 302 Version AF | 2013-05 Deutsch Projektierung", Mai 2013 (2013-05) offenbart auch, wie Schraubsystemparameter verwaltet werden können.

Derartige zuvor genannte Verfahren zur Zuordnung von einer einen Schraubvorgang beschreibenden Schraubkurve zu einem die Schraubkurve steuernden Schraubprogramm sind bereits aus dem Stand der Technik wohl bekannt. Bekannt sind nämlich solche Lösungen, in welchen ein Benutzer Schraubprogramme und Schraubkurven auf einem Dateisystem speichert und versucht, über ein Speicherdatum der Schraubkurven auf dem Filesystem Rückschlüsse darauf zu ziehen, welches Schraubprogramm einer gespeicherten Schraubkurve zugeordnet werden kann. Grundsätzlich wird nämlich ein Benutzer, beispielsweise ein Kunde, von dem Gedanken geleitet, dass vorhandene Schraubkurven mit Schraubprogrammen in Verbindung gebracht werden, da die Parameter des Schraubprogramms direkten Einfluss auf die Schraubkurve haben.

Es wurde jedoch erkannt, dass eine derartige Zuordnung von Schraubkurven zu Schraubprogrammen allein durch das Speicherdatum der Schraubkurven innerhalb des Filesystems nur wenig prozesssicher ist, da oftmals keine eindeutige Zuordnung gewährleistet ist. Eine derartige zeitliche Zuordnung bedeutet nämlich eine recht fehleranfällige manuelle Zuordnung der einzelnen Konfigurationselemente und Ablaufketten zu der Schraubkurve bzw. Ergebnisdaten. Mit anderen Worten ist ein Speicherdatum als eindeutiger, vorzugsweise eineindeutiger Rückschluss auf ein einmal benutztes Schraubprogramm oder eine einmal durchgeführte Schraubkurve oftmals nicht ausreichend oder gar nicht möglich, da lediglich das Speicherdatum an sich es beispielsweise nicht ausschließt, dass zum gleichen Zeitpunkt mehrere Schraubprogramme verschiedene oder ähnliche Schraubkurven erzeugt haben. Zum gleichen Speicherdatum wären dann beispielsweise mehrere Schraubkurven und/oder mehrere Schraubprogramme betrieben gewesen.

Insofern können in einem Produkthaftungsfall keine eindeutigen Rückschlüsse auf das verwendete Schraubprogramm geschlossen werden. Ebenfalls können keine weiteren Einflussparameter auf die Ergebnisdaten zugeordnet werden (Systemkonfiguration, Qualitätscode-Matrix, ...).

Eine Aufgabe der vorliegenden Erfindung ist es, das oben genannte Problem zu vermeiden und insofern ein Verfahren zur Zuordnung von einer einen Schraubvorgang beschreibenden Schraubkurve zu einem die Schraubkurve steuernden Schraubprogramm in eindeutiger, vorzugsweise eineindeutiger Weise besonders einfach und kostengünstig zu ermöglichen.

Diese Aufgabe wird durch den Gegenstand der Patentansprüche 1 und 6 gelöst. Vorteilhafte weitere Ausgestaltungen sind in den abhängigen Ansprüchen angegeben.

Um nun ein Verfahren zur Zuordnung von einer einen Schraubvorgang beschreibenden Schraubkurve zu einem die Schraubkurve steuernden Schraubprogramm in besonders einfacher und kostengünstiger Art und Weise zu ermöglichen, macht die vorliegende Erfindung unter anderem von der Idee Gebrauch, dass mittels eines Ermittlungsmoduls zumindest ein Schraubprogramm, eine Schraubkurve sowie eine Schraubsystemkonfiguration eines Schraubsystems eindeutig, vorzugsweise eineindeutig einander, insbesondere zeitlich rückwirkend, zugeordnet werden.

Dabei kann es sich bei dem hier beschriebenen Ermittlungsmodul um ein separates Bauteil handeln, auf dem eine Ermittlungssoftware betrieben wird oder betreibbar ist. Mittels des hier beschriebenen Ermittlungsmoduls wird es daher in besonders einfacher und kostengünstiger Art und Weise ermöglicht, prozesssicher eine eindeutige, vorzugweise eineindeutige Zuordnung zwischen dem Schraubprogramm, der Schraubkurve und der Schraubsystemkonfiguration zu ermöglichen.

In diesem Zusammenhang sei erwähnt, dass mit den Begriffen "Schraubkurve" ein Verlauf eines Einschraubdrehmoments in Abhängigkeit der Drehposition einer einzudrehenden Schraube gemeint ist.

Mit dem Begriff "Schraubsystemkonfiguration" wird zumindest ein Betriebszustand eines Schraubsystems, welches die hier beschriebene Schraubkurve mittels des hier beschriebenen Schraubprogramms erzeugt, bezeichnet. "Konfiguration" bezeichnet insofern eine Einstellung des Schraubsystems in Bezug auf softwarebasierte Einstellparameter, wobei eine Konfiguration eindeutig, vorzugsweise eineindeutig einer vorgebbaren Kombination derartiger softwarebasierter Einstellparameter zugeordnet werden kann.

Insofern ist eine Versionierung der Schraubprogramme und der Systemkonfiguration für eine eindeutige Zuordnung dieser Elemente zu einer Schraubkurve bzw. deren Ergebnisdaten ermöglicht. Die Versionierung kann sich dabei auf alle Konfigurationsdateien und/oder Schraubparameter und Ablaufketten im Schraubsystem beziehen oder auf diese erweitert werden.

Mit anderen Worten ist es durch die Einführung eines Änderungswesens ermöglicht, dass eine Historie in zeitlicher Hinsicht von verschiedenen Schraubvorgängen besonders einfach nachvollzogen werden kann und der Systemzustand beispielsweise zu einem beliebigen Zeitpunkt wiederhergestellt werden kann.

Fehleranfällige manuelle, insbesondere zeitliche, Zuordnungen der einzelnen Konfigurationselemente und Ablaufketten zu Schraubkurven bzw. Ergebnisdaten werden daher vermieden, so dass durch das Änderungsmanagement die Historie besonders einfach eindeutig nachvollzogen werden kann.

Das Verfahren zur Zuordnung von einer einen Schraubvorgang beschreibenden Schraubkurve zu einem die Schraubkurve steuernden Schraubprogramm umfasst ein Ermittlungsmodul, mittels dessen zumindest ein Schraubprogramm, eine Schraubkurve sowie eine Schraubsystemkonfiguration eines Schraubsystems eindeutig, vorzugsweise eineindeutig einander, insbesondere zeitlich rückwirkend, zugeordnet werden.

Über die Zuordnung des Ermittlungsmoduls wird eindeutig, vorzugsweise eineindeutig eine Identifizierung desjenigen Schraubprogramms, das zum Zeitpunkt der Verschraubung benutzt wurde, zu dem die Schraubkurve entstanden ist, ermöglicht. Mit anderen Worten wird bei einer derartigen Konfiguration nicht nur eine eineindeutige Zuordnung des Schraubprogramms, der Schraubkurve und der Schraubsystemkonfiguration gewährleistet, sondern es kann ganz konkret bei Information und Identifizierung des Schraubprogramms allein und/oder in Kombination mit der Schraubsystemkonfiguration auf die jeweilige Schraubkurve zurückgeschlossen werden. Schraubkurven können daher beispielsweise im Produkthaftungsfall und für versicherungstechnische Angelegenheiten eindeutig versioniert wiedergegeben werden.

Dazu kann das Schraubprogramm auf einem Dateisystem gespeichert werden. Das Dateisystem ist auf dem Ermittlungsmodul hinterlegt. In einer nicht erfindungsgemäßen Ausführungsform ist zwischen dem Ermittlungsmodul und einem derartigen Speichermodul eine Kommunikationsverbindung drahtlos oder drahtgebunden zum Kommunikationsaustausch hergestellt.

Gemäß zumindest einer Ausführungsform kann eine Schraubsystemkonfiguration des Schraubsystems, mittels dem eine Schraube in ein Objekt eingeschraubt wurde, durch die eindeutige Zuordnung des Ermittlungsmoduls zumindest teilweise, vorzugsweise jedoch vollständig wiederhergestellt werden. Mit anderen Worten ist es insofern ermöglicht, dass durch ein derartiges "Backup-System" ein Schraubprogramm, welches beispielsweise zu einer fehlerhaft eingeschraubten Schraube geführt hat, zu Simulationszwecken nochmals betrieben wird, um den fehlerhaften Schraubvorgang nochmals nachfahren zu können.

Die Schraubkurve ist auf einem Speichermedium gespeichert, insbesondere protokolliert, wobei das Ermittlungsmodul dazu eingerichtet und dafür vorgesehen ist, die gespeicherte Schraubkurve abzurufen. Mit anderen Worten kann durch ein derartiges Abspeichern der Schraubkurve auf dem Speichermedium die Schraubkurve nicht nur eindeutig identifiziert werden, sondern es kann die hier beschriebene Schraubkurve auch in protokollarischer Hinsicht nochmals betrieben werden.

Darüber hinaus umfasst die vorliegende Anmeldung ebenso eine Vorrichtung zur Zuordnung von einer einen Schraubvorgang beschreibenden Schraubkurve zu einem die Schraubkurve steuernden Schraubprogramm. Dabei ist für die hier beschriebene Vorrichtung jedes der im Zusammenhang mit dem hier beschriebenen Verfahren offenbarten Merkmale offenbart und umgekehrt.

Die Vorrichtung umfasst zur Zuordnung von einer einen Schraubvorgang beschreibenden Schraubkurve zu einem die Schraubkurve steuernden Schraubprogramm ein Ermittlungsmodul, mittels dessen zumindest ein Schraubprogramm, eine Schraubkurve sowie eine Schraubsystemkonfiguration eines Schraubsystems eindeutig, vorzugsweise eineindeutig einander, zeitlich rückwirkend, zuordenbar sind, wie in Anspruch 1 beschrieben.

Die hier beschriebene Vorrichtung zur Zuordnung von einer einen Schraubvorgang beschreibenden Schraubkurve zu einem die Schraubkurve steuernden Schraubprogramm weist daher die gleichen Vorteile und Ausgestaltungen wie im Zusammenhang mit dem hier beschriebenen Verfahren auf.

Im Folgenden werden das hier beschriebene Verfahren sowie die hier beschriebene Vorrichtung anhand einer Figur sowie dem dazugehörigen Ausführungsbeispiel näher erläutert.

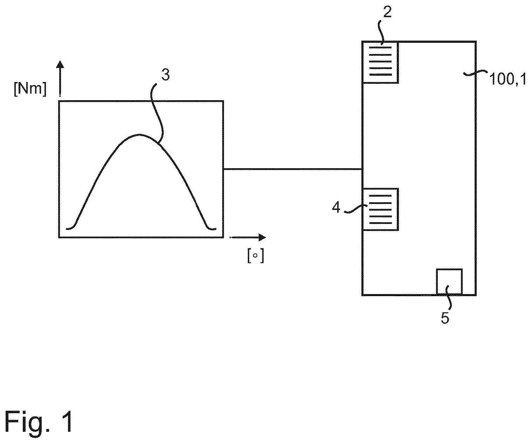

Die Fig. 1 zeigt ein Ausführungsbeispiel eines Verfahrens sowie einer Vorrichtung zur Zuordnung von einer einen Schraubvorgang beschreibenden Schraubkurve zu einem die Schraubkurve steuernden Schraubprogramm.

In dem Ausführungsbeispiel und der Figur sind gleiche oder gleichwirkende Bestandteile jeweils mit den gleichen Bezugszeichen versehen. Die hier dargestellten Elemente sind nicht als maßstabsgerecht anzusehen, vielmehr können einzelne Elemente zum besseren Verständnis übertrieben groß dargestellt sein.

In der Fig. 1 ist anhand einer schematischen Darstellung ein Ausführungsbeispiel eines hier beschriebenen Verfahrens zur Zuordnung von einer einen Schraubvorgang beschreibenden Schraubkurve 3 zu einem die Schraubkurve 3 steuernden Schraubprogramm 2 gezeigt.

Dazu weist eine Vorrichtung 100, mittels der das hier beschriebene Verfahren betrieben wird, ein Ermittlungsmodul 1 auf, mittels dessen das Schraubprogramm 2, eine Schraubkurve 3 sowie eine Schraubsystemkonfiguration 4 eines Schraubsystems eindeutig einander zeitlich rückwirkend zugeordnet werden. Dabei wird über die Zuordnung des Ermittlungsmoduls 1 in eineindeutiger Weise eine Identifizierung desjenigen Schraubprogramms 2, das zum Zeitpunkt der Verschraubung benutzt wurde, zu dem die Schraubkurve 3 entstanden ist, ermöglicht.

Dies ist dadurch gewährleistet, als dass jede Schraubkurve 3 auf einem Speichermedium 5 (ein Bauteil des Ermittlungsmoduls 1) gespeichert ist, auf dem die Schraubkurven 3 auch protokolliert sind, so dass das Ermittlungsmodul 1 nur noch die auf dem Speichermedium 5 hinterlegten Schraubkurven 3 abrufen muss. Es sind auf dem Speichermedium 5 neben den Schraubkurven 3 auch entsprechende Schraubprogramme 2 sowie Schraubsystemkonfigurationen 4 hinterlegt.

Die Erfindung ist nicht durch die Beschreibung anhand des Ausführungsbeispiels beschränkt.

### Bezugszeichenliste

- 1: Ermittlungsmodul
- 2: Schraubprogramm
- 3: Schraubkurve
- 4: Schraubsystemkonfiguration
- 5: Speichermedium
- 100: Vorrichtung

## Patentansprüche

1. Verfahren zur Zuordnung von einer einen Schraubvorgang beschreibenden Schraubkurve zu einem die Schraubkurve (3) steuernden Schraubprogramm (2) bei einem Schraubsystem, bei welchem zum gleichen Zeitpunkt mehrere Schraubkurven und/oder mehrere Schraubprogramme betrieben werden können,
**dadurch gekennzeichnet, dass**
eine Vorrichtung (100), mittels der das Verfahren betrieben wird, ein Ermittlungsmodul aufweist, mittels des Ermittlungsmoduls (1) Schraubkurve (3) mit der eine Schraube eingeschraubt wurde, ein Schraubprogramm (2) sowie eine Schraubsystemkonfiguration (4) des Schraubsystems zugeordnet werden, um den Zustand des Schraubsystems zu einem beliebigen Zeitpunkt wiederherzustellen und um auf die zum Einschrauben der Schraube verwendete Schraubkurve (3) zurückzuschließen, wobei die Schraubsystemkonfiguration (4) eindeutig einer Kombination von softwarebasierten Einstellparametern zugeordnet ist, auf welche das Schraubsystem beim Einschrauben der Schraube mit dem Schraubprogramm (2) eingestellt war,
mittels der Zuordnung des Ermittlungsmoduls (1) eine Versionierung des Schraubprogramms (2) und der Schraubsystemkonfiguration (4) für eine eindeutige Zuordnung des Schraubprogramms (2) sowie der Schraubsystemkonfiguration (4) zu der Schraubkurve (3) ermöglicht wird, und
die Schraubkurve (3) eindeutig versioniert aus einem Speichermedium (5) des Ermittlungsmoduls (1) wiedergegeben wird.

2. Verfahren nach Anspruch 1,
**dadurch gekennzeichnet, dass**
der Zustand des Schraubsystems zu dem beliebigen Zeitpunkt wiederhergestellt wird und die zum Einschrauben der Schraube verwendete Schraubkurve (3) mit dem Schraubprogramm (2), das zum Zeitpunkt der Verschraubung benutzt wurde zu dem die Schraubkurve (3) entstanden ist zu Simulationszwecken nochmals betrieben wird.

3. Verfahren nach Anspruch 1 oder 2,
**dadurch gekennzeichnet, dass**
das Schraubprogramm (2) auf einem Dateisystem gespeichert ist.

4. Verfahren nach zumindest einem der vorhergehenden Ansprüche,
**dadurch gekennzeichnet, dass**
eine Schraubsystemkonfiguration (4) des Schraubsystems, mittels dem eine Schraube in ein Objekt eingeschraubt wurde, durch die Zuordnung des Ermittlungsmoduls (1) zumindest teilweise, wiederhergestellt wird.

5. Verfahren nach zumindest einem der vorhergehenden Ansprüche,
**dadurch gekennzeichnet, dass**
die Schraubkurve (3) auf dem Ermittlungsmodul (1) oder einem von dem Ermittlungsmodul (1) getrennt angeordneten Speichermedium (5) gespeichert ist, wobei das Ermittlungsmodul (1) dazu eingerichtet und dafür vorgesehen ist die gespeicherte Schraubkurve (3) abzurufen.

6. Vorrichtung (100) zur Zuordnung von einer einen Schraubvorgang beschreibenden Schraubkurve zu einem die Schraubkurve (3) steuernden Schraubprogramm (2) bei einem Schraubsystem, bei welchem zum gleichen Zeitpunkt mehrere Schraubkurven und/oder mehrere Schraubprogramme betrieben werden können,
wobei die Vorrichtung (100) ein Ermittlungsmodul (1) aufweist, das ausgestaltet ist, einer Schraubkurve (3), mit der eine Schraube eingeschraubt wurde, ein Schraubprogramm (2) und eine Schraubsystemkonfiguration (4) des Schraubsystems, zuzuordnen, um den Zustand des Schraubsystems zu einem beliebigen Zeitpunkt wiederherzustellen und um auf die zum Einschrauben der Schraube verwendete Schraubkurve (3) zurückzuschließen, wobei die Schraubsystemkonfiguration (4) eindeutig einer Kombination von softwarebasierten Einstellparametern zugeordnet ist, auf welche das Schraubsystem beim Einschrauben der Schraube mit dem Schraubprogramm eingestellt war,
wobei mittels der Zuordnung des Ermittlungsmoduls (1) eine Versionierung des Schraubprogramms (2) und der Schraubsystemkonfiguration (4) für eine eindeutige Zuordnung des Schraubprogramms (2) sowie der Schraubsystemkonfiguration (4) zu der Schraubkurve (3) ermöglicht wird, und
wobei die Schraubkurve (3) eindeutig versioniert aus einem Speichermedium (5) des Ermittlungsmoduls (1) wiedergebbar ist.

## Claims

1. Method for associating a screwing curve describing a screwing process with a screwing program (2) controlling the screwing curve (3) in a screwing system in which multiple screwing curves and/or multiple screwing programs can be operated at the same time,
**characterized in that**
an apparatus (100) used to operate the method has a determining module,
the determining module (1) is used to associate a screwing program (2) and a screwing system configuration (4) of the screwing system with a screwing curve (3) that was used to screw in a screw, in order to restore the state of the screwing system at an arbitrary time and in order to infer the screwing curve (3) used to screw in the screw, the screwing system configuration (4) being uniquely associated with a combination of software-based setting parameters to which the screwing system was set for screwing in the screw using the screwing program (2),
the association of the determining module (1) is used to allow versioning of the screwing program (2) and of the screwing system configuration (4) for a unique association of the screwing program (2) and of the screwing system configuration (4) with the screwing curve (3), and
the screwing curve (3) is reproduced in uniquely versioned form from a storage medium (5) of the determining module (1).

2. Method according to Claim 1,
**characterized in that**
the state of the screwing system at the arbitrary time is restored and the screwing curve (3) used for screwing in the screw is operated again for simulation purposes using the screwing program (2) that was used at the time of screwing at which the screwing curve (3) was produced.

3. Method according to Claim 1 or 2,
**characterized in that**
the screwing program (2) is stored on a file system.

4. Method according to at least one of the preceding claims,
**characterized in that**
a screwing system configuration (4) of the screwing system that was used to screw a screw into an object is restored, at least in part, by the association of the determining module (1).

5. Method according to at least one of the preceding claims,
**characterized in that**
the screwing curve (3) is stored on the determining module (1) or a storage medium (5) arranged separately from the determining module (1), the determining module (1) being set up and intended to retrieve the stored screwing curve (3).

6. Apparatus (100) for associating a screwing curve describing a screwing process with a screwing program (2) controlling the screwing curve (3) in a screwing system in which multiple screwing curves and/or multiple screwing programs can be operated at the same time,
wherein the apparatus (100) has a determining module (1) designed to associate a screwing program (2) and a screwing system configuration (4) of the screwing system with a screwing curve (3) that was used to screw in a screw, in order to restore the state of the screwing system at an arbitrary time and in order to infer the screwing curve (3) used to screw in the screw, the screwing system configuration (4) being uniquely associated with a combination of software-based setting parameters to which the screwing system was set for screwing in the screw using the screwing program,
wherein the association of the determining module (1) is used to allow versioning of the screwing program (2) and of the screwing system configuration (4) for a unique association of the screwing program (2) and of the screwing system configuration (4) with the screwing curve (3), and
wherein the screwing curve (3) is reproducible in uniquely versioned form from a storage medium (5) of the determining module (1).

## Revendications

1. Procédé d'association d'une courbe de vissage décrivant un processus de vissage à un programme de vissage (2) commandant la courbe de vissage (3) dans un système de vissage dans lequel plusieurs courbes de vissage peuvent être utilisées et/ou plusieurs programmes de vissage peuvent être exécutés en même temps,
**caractérisé en ce que**
un dispositif (100), au moyen duquel le procédé est mis en œuvre, comporte un module de détermination,
le module de détermination (1) permet d'associer une courbe de vissage (3), avec laquelle une vis a été vissée, un programme de vissage (2) et une configuration de système de vissage (4) du système de vissage afin de rétablir l'état du système de vissage à tout moment et tirer des conclusions sur la courbe de vissage (3) utilisée pour visser la vis, la configuration (4) du système de vissage étant associée de manière univoque à une combinaison de paramètres de réglage logiciels sur lesquels le système de vissage a été réglé lors du vissage de la vis avec le programme de vissage (2),
l'association du module de détermination (1) permet d'établir une version du programme de vissage (2) et de la configuration (4) du système de vissage pour une association univoque du programme de vissage (2) et de la configuration (4) du système de vissage à la courbe de vissage (3), et
la courbe de vissage (3) est reproduite de manière univoque en termes de version à partir d'un support de stockage (5) du module de détermination (1).

2. Procédé selon la revendication 1,
**caractérisé en ce que**
l'état du système de vissage est rétabli à tout moment et la courbe de vissage (3) utilisée pour le vissage de la vis est réexploitée à des fins de simulation avec le programme de vissage (2) qui était utilisé au moment du vissage auquel la courbe de vissage (3) a été créée.

3. Procédé selon la revendication 1 ou 2,
**caractérisé en ce que**
le programme de vissage (2) est mémorisé dans un système de fichiers.

4. Procédé selon l'une au moins des revendications précédentes,
**caractérisé en ce que**
une configuration (4) du système de vissage, au moyen duquel une vis a été vissée dans un objet, est au moins partiellement rétablie par association du module de détermination (1).

5. Procédé selon l'une au moins des revendications précédentes,
**caractérisé en ce que**
la courbe de vissage (3) est mémorisée sur le module de détermination (1) ou sur un support de stockage (5) disposé séparément du module de détermination (1), le module de détermination (1) étant conçu et prévu pour récupérer la courbe de vissage mémorisée (3).

6. Dispositif (100) d'association d'une courbe de vissage décrivant un processus de vissage à un programme de vissage (2) commandant la courbe de vissage (3) dans un système de vissage dans lequel plusieurs courbes de vissage peuvent être utilisées et/ou plusieurs programmes de vissage peuvent être exécutés en même temps,
le dispositif (100) comportant un module de détermination (1) qui est conçu pour associer une courbe de vissage (3), avec laquelle une vis a été vissée, un programme de vissage (2) et une configuration (4) du système de vissage afin de rétablir l'état du système de vissage à tout moment et tirer des conclusions sur la courbe de vissage (3) utilisée pour visser la vis, la configuration (4) du système de vissage étant associée de manière univoque à une combinaison de paramètres de réglage logiciels sur lesquels le système de vissage a été réglé lors du vissage de la vis avec le programme de vissage,
l'association du module de détermination (1) permettant d'établir une version du programme de vissage (2) et de la configuration (4) du système de vissage pour une association univoque du programme de vissage (2) et de la configuration (4) du système de vissage à la courbe de vissage (3), et
la courbe de vissage (3) pouvant être reproduite de manière univoque en termes de version à partir d'un support de stockage (5) du module de détermination (1).
